**Europäisches Patentamt**

**European Patent Office**

**Office européen des brevets**

(19)

(11) Veröffentlichungsnummer: **0 010 139**
**B1**

(12) **EUROPÄISCHE PATENTSCHRIFT**

(45) Veröffentlichungstag der Patentschrift: **18.05.83**

(51) Int. Cl.³: **G 11 C 17/00**

(21) Anmeldenummer: **79103106.5**

(22) Anmeldetag: **23.08.79**

(54) FET-Speicherzelle für Festwertspeicher.

(30) Priorität: **24.10.78 US 954947**

(43) Veröffentlichungstag der Anmeldung:
**30.04.80 Patentblatt 80/9**

(45) Bekanntmachung des Hinweises auf die Patenterteilung:
**18.05.83 Patentblatt 83/20**

(84) Benannte Vertragsstaaten:
**DE FR GB**

(56) Entgegenhaltungen:
**GB - A - 1 131 210**
**US - A - 3 590 340**
**US - A - 3 740 523**
**US - A - 3 914 855**

**MOS/LSI DESIGN AND APPLICATION, McGraw Hill, 1972,**
**New York, US,**
**CARR et al.: "Read-only memory (ROM)",**
**Seiten 196—202**

(73) Patentinhaber: **International Business Machines Corporation**
**Armonk, N.Y. 10504 (US)**

(72) Erfinder: **Bertin, Claude L.**
**33 Pheasant Way**
**South Burlington, VT 05401 (US)**
Erfinder: **Bula, John**
**10 Creek Road**
**Essex, VT 05451 (US)**
Erfinder: **Martin, Larry C.**
**8030 E. Ft. Lowell Road**
**Tucson, Arizona 85715 (US)**
Erfinder: **Williams, Thomas A.**
**10806 Hunt Club Road**
**Reston, VA 22090 (US)**

(74) Vertreter: **Böhmer, Hans Erich, Dipl.-Ing.**
**Schönaicher Strasse 220**
**D-7030 Böblingen (DE)**

(56) Entgegenhaltungen:
IBM TECHNICAL DISCLOSURE BULLETIN, Vol.
19, Nr. 4, September 1976,
Armonk, US,
DELIDUKA et al.: "Monolithic integrated circuit
fuse link", Seite 1161

IEEE JOURNAL OF SOLID-STATE CIRCUITS,
Vol. SC-11, Nr. 4, August 1976,
New York, US,
NORTH et al.: "Laser coding of Bipolar ROM",
Seiten 500—505

ELECTRONICS, Vol. 47, Nr. 5, 7 März 1974,
New York, US,
HUBER et al.: "Simplified N-channel process
achieves high performance", Seiten 117—122

ELECTRONICS, Vol. 42, Nr. 4, 17. Februar 1969,
New York, US,
LUISI: "SOS brings new life to read-only units",
Seiten 114—119

IBM TECHNICAL DISCLOSURE BULLETIN, Vol.
20, Nr. 3, August 1977,
Armonk, US,
FURLONG et al.: "Latent images in charge
storage memories", Seite 951

1977 IEEE INTERNATIONAL SOLID-STATE
CIRCUITS CONFERENCE, 18. Februar 1977,
New York, US,
SCHROEDER et al.: "A 1024-bit-fused-link
CMOS PROM", Digest of technical papers",
Seiten 190—191

IBM TECHNICAL DISCLOSURE BULLETIN, Vol.
15, Nr. 8, Januar 1973,
Armonk, US,
COOK et al.: "ROM fabrication by laser formed
connections", Seiten 2371—2372

## FET-Speicherzelle für Festwertspeicher

Die Erfindung betrifft eine Feldeffekttransistor-Speicherzelle für Festwertspeicher, bei dem Speicherplätze wahlweise zur Programmierung des Festwertspeichers vom Rest der Festwertspeicherschaltung abgetrennt werden können.

Bisher bekannte, aus Feldeffekttransistoren aufgebaute Festwertspeicheranordnungen bestehen aus rechtwinkligen Anordnungen von Feldeffekttransistoren, deren Gateelektroden an einer Spalten- oder Wortleitung angeschlossen sind, während die Drainelektroden beispielsweise an einem Bezugspotential und die Sourceelektroden beispielsweise in Zeilen an Bit-Abfühlleitungen angeschlossen sind. Die Festwertspeicheranordnung wird für eine bestimmte Bit-Konfiguration dadurch programmiert, daß selektiv die Gateleitungen für ausgewählte Feldeffekttransistoren aufgetrennt werden, so daß die verbleibenden FETs die zu speichernde Information darstellen. Die Verfahren zum Abtrennen von ausgewählten Gateelektroden von den Wortleitungen sind dabei folgende: Ein programmierbares Maskenverfahren zum Aufbauen einer dicken Oxidschicht im Gatebereich für den ausgewählten Feldeffekttransistor oder in einer späteren Stufe der Herstellung das selektive Abätzen des Gateanschlusses für den Feldeffekttransistor oder aber die Auftrennung der Verbindung zwischen der Gateelektrode des FET und der Wortleitung durch elektrisches Schmelzen der Verbindung mit einem starken Strom oder durch Abschmelzen der Verbindung durch Anwendung eines Laserstrahls.

Die Erfahrung hat gezeigt, daß sich auf der Gateelektrode und der zugehörigen Anschlußleitung wegen der Behandlung vor dem Auftrennen der Leitung statische elektrische Ladungen ansammeln und nach Auftrennen der Gateleitung auf der Gateelektrode isoliert werden. Dadurch ergibt sich ein unvorhersehbarer Leitungszustand für den Feldeffekttransistor anstelle des gewünschten eindeutigen Sperrzustandes.

Die Schwere dieses Problems hängt von der Güte der Isolierschicht zwischen der Gateelektrode und dem Substrat an dem ausgewählten FET ab, dessen Gateelektrode auf diese Weise abgetrennt ist. Hat der Gate-Isolator einen sehr hohen spezifischen Widerstand, dann wird nur sehr wenig Ladung über einen Leckstrompfad aus der auf der Gateelektrode angesammelten Ladung nach dem Substrat abfließen, und der unvorhersehbare Leitungszustand des Feldeffekttransistors wird für eine längere Zeit, möglicherweise für Monate oder sogar Jahre, erhalten bleiben. Die Auswirkung einer solchen auf einer abgetrennten Gateelektrode angesammelten Ladung besteht darin, daß dan, wenn die Bit-Leitungen durch Abfühlverstärker abgefragt werden, ein fehlerhafter Leitungszustand festgestellt wird.

Es sind bereits verschiedene Versuche unternommen worden, um die Ansammlung einer Restladung auf der Gateelektrode eines abgetrennten Gates eines Feldeffekttransistors möglichst klein zu machen, jedoch hat sich bis heute keine zufriedenstellende Lösung ergeben. Im IBM Technical Disclosure Bulletin, Sept. 1976, Seite 1161, ist eine monolithische integrierte Schaltung mit einer Schmelzverbindung offenbart. Die integrierte Schaltung wird dabei im Laufe der Herstellung einer Behandlung ausgesetzt, und zum Schutz der Schaltung von elektrostatischen Ladungen ist eine Schutzdiode an die Schaltung über die Schmelzverbindung angeschlossen. Ist die Behandlung abgeschlossen, wird die Schmelzverbindung aufgetrennt. Die Schmelzverbindung trennt damit die Schutzdiode von der zu schützenden Schaltung ab, so daß das der Erfindung zugrunde liegende Problem, nämlich das Vorhandensein irgendeiner auf der Gateelektrode angesammelten Ladung in der integrierten Schaltung, nachdem die Schaltung aufgetrennt worden ist, hier nicht angesprochen ist.

Andere physikalische Erscheinungen können ebenfalls unbeabsichtigterweise Ladungen auf einer abgetrennten Gateelektrode eines Feldeffekttransitors erzeugen, woraus sich für diesen Feldeffekttransistor ein nicht vorhersehbarer Leitungszustand ergibt. Beispielsweise kann sich eine photoelektrische Aufladung dadurch ergeben, daß die abgetrennte Gateelektrode dem Tageslicht ausgesetzt wird, so daß sich der Leitungszustand des FET ändert. Außerdem kann eine Ionenverunreinigung von versehentlich eingeführten Natriumionen eine allmähliche elektrostatische Aufladung der abgetrennten Gateelektrode verursachen, wodurch sich wiederum der unvorhersehbare Leitungszustand des FET ergibt. Bei diesen Erscheinungen, die eine versehentliche Aufladung der Gateelektrode nach ihrer Abtrennung von der Wortleitung zur Folge haben, ergeben sich nicht vorhersehbare Leitungsprobleme, die durch bisher bekannte Verfahren nicht beseitigt werden. Schließlich kann die Einkopplung von elektrischen Streufeldern die Ansammlung einer Ladung auf einer nicht angeschlossenen Gateelektrode zur Folge haben, welche dann einen Entladestromkreis benötigt.

Die Aufgabe der Erfindung läßt sich also aus diesen Ausführungen dahingehend ableiten, daß eine Speicherzelle mit einem Feldeffekttransistor für einen Festwertspeicher geschaffen werden soll, die auch nach Auftrennung der zur Gateelektrode führenden Leitung einen voraussehbaren stabilen Leitungszustand aufweist.

Diese der Erfindung zugrunde liegende Aufgabe wird in folgender Weise gelöst:

In einer Speicherzelle für einen Festwertspeicher ist eine an der Gateelektrode eines Feldeffekttransistors angeschlossene Diode zur

Ableitung von Restladungen offenbart.

Der Festwertspeicher wird dadurch hergestellt, daß ausgewählte Gateleitungen in einer Anordnung von Feldeffekttransistoren mit einem Laserstrahl aufgetrennt werden. Die Erfahrung hat gezeigt, daß die statischen elektrischen Aufladungen auf der Leitung, die sich durch eine Behandlung vor Auftrennen der Leitung angesammelt haben, an der Gateelektrode nach Auftrennen der Gateleitung isoliert werden, so daß für den Feldeffekttransistor ein nicht vorhersehbarer Leitungszustand erzeugt wird, statt dem stabilen Sperrzustand, der gewünscht wird. Indem man eine Ableitdiode vorsieht, die auch an der Gateelektrode des FET angeschlossen bleibt, nachdem die Auftrennung der Gateleitung durchgeführt ist, können die Ladungen derjenigen FETs, deren Gateleitungen aufgetrennt worden sind, abgeleitet werden, während gleichzeitig dadurch verhindert wird, daß die Spannung an der Gateelektrode des FET unbestimmt bleibt. Die Diode ist dabei so gepolt, daß sie einen hohen Widerstand für einen vom Gateknotenpunkt abfließenden Strom darstellt, wenn die Gateelektrode absichtlich für den Leitzustand des FET vorgespannt ist. Dadurch wird der Einfluß der Diode auf die Schaltgeschwindigkeit klein gehalten, wenn die Gateelektrode mit dem Rest der Schaltung des Festwertspeichers verbunden bleibt. Ist die Gateelektrode und damit die Diode selektiv vom Rest der Festwertspeicherschaltung bei der Programmierung des Speichers abgetrennt worden, dann wird jede Restladung auf der Gateelektrode über die Diode abgeleitet, und zwar entweder durch den Leckstrom bei einer Vorspannung in Sperrichtung oder normal bei einer Vorspannung in Durchlaßrichtung, je nach der Polarität der Restladung auf der Gateelektrode.

Die Erfindung wird nunmehr anhand von Ausführungsbeispielen in Verbindung mit den beigefügten Zeichnungen im einzelnen näher erläutert.

In den Zeichnungen zeigen

Fig. 1 schematisch einen Teil einer Festwertspeicheranordnung mit einer durch Laserstrahl abtrennbaren Speicherzelle gemäß der Erfindung,

Fig. 2 eine Draufsicht auf einen ausgewählten Teil einer durch Laserstrahl abgetrennten Speicherzelle mit der Ableitdiode und

Fig. 3 ein Schaltbild einer einzigen FET-Festwertspeicherzelle.

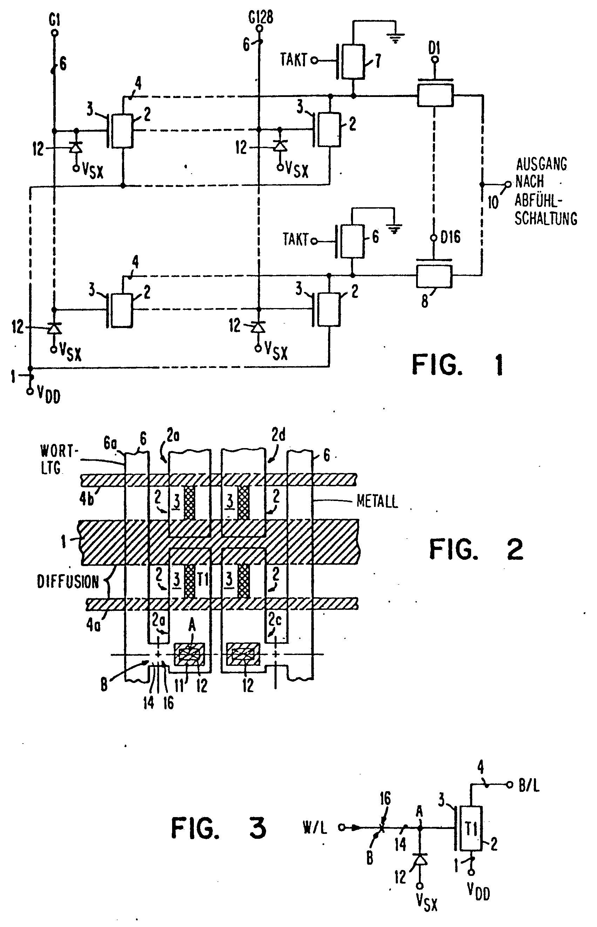

Fig. 1 zeigt ein Schaltbild eines Teils eines FET-Festwertspeichers mit einer Ableitdiode. Die Schaltung ist dabei in waagerechten Zeilen von FETs angeordnet, deren Drainelektroden gemeinsam am Drainpotential $V_{DD}$ und deren Sourceelektroden gemeinsam an den Bit-Abfühlleitungen 4 angeschlossen sind. Die Feldeffekttransistoren 2 sind dabei in vertikalen Spalten angeordnet, wobei in jeder Spalte die Gateelektroden gemeinsam an einer der mit G1 ... bis G128 bezeichneten Wortleitungen 6 angeschlossen sind. Die Speicheranordnung wird nach Herstellung der Gateelektroden für alle Feldeffekttransistoren dadurch selektiv programmiert, daß wahlweise die Gateanschlußleitungen für ausgewählte Feldeffekttransistoren dadurch aufgetrennt werden, daß sie durch einen Laserstrahl getroffen werden, wodurch die Gateanschlüsse an die Wortleitungen 6 unterbrochen werden. Wenn im Betrieb eine der Wortleitungen 6 impulsmäßig angesteuert wird, dann gehen diejenigen FETs 2, deren Gateelektroden immer noch an der impulsmäßig angesteuerten Wortleitung 6 angeschlossen sind, in den Leitzustand über und schalten damit das Potential $V_{DD}$ der Drainelektrode nach der Bit-Leitung 4 durch, so daß dieses Potential über einen Ausgangstransistor 8 nach einem Ausgangsknotenpunkt 10 weitergeleitet wird, der an einem Abfühlverstärker angeschlossen ist.

Wie bereits erwähnt, ist der FET 2 mit seiner Drainelektrode an der Drainspannung $V_{DD}$, mit seiner Sourceelektrode über die Bit-Leitung 4 am ausgangsknotenpunkt 10 und mit seiner Gateelektrode an der Eingangswortleitung 6 angeschlossen und kann für die Speicherung eines binären Informationsbits durch Abtrennung der Gateelektrode von der Wortleitung 6 programmiert werden. Bei durch Laserstrahl programmierbaren Festwertspeicherzellen sind im allgemeinen die Feldeffekttransistoren der Speicheranordnung voll ausgebildet, wobei die Gateelektroden an den entsprechenden Wortleitungen angeschlossen sind. In diesem Zustand können Festwertspeicher auf Lager gehalten werden. Wenn für bestimmte Anwendungsgebiete Festwertspeicher benötigt werden, so können diese vom Lager geholt und entsprechend der Programmierung können dann mit Hilfe eines Laserstrahls die entspechenden Gateelektroden der ausgewählten Feldeffekttransistoren durch einen Laserstrahl abgetrennt werden, so daß damit der Festwertspeicher dauerhaft programmiert wird. Diese Programmierung kann beispielsweise über eine optisch transparente, aus Quarz bestehende Passivierungsschicht durchgeführt werden. Das sich dabei ergebende Verfahren läßt ein schnelles Eingehen auf besondere Anwendungsgebiete zu.

Die Feldeffekttransistoren einer solchen Speicheranordnung können entweder N-Kanal-Transistoren sein, bei denen das Substrat P-leitend ist, oder sie können P-Kanal-Transistoren sein, bei denen das Substrat N-leitend ist, wie dies Fig. 2 zeigt. Ein N-Kanal-FET wird beispielsweise dadurch hergestellt, daß man N-leitende Diffusionszonen für Source- und Drainzone in das P-leitende Substrat eindiffundiert. In einem Feldeffekttransistor vom Anreicherungstyp wird ein N-Kanal-FET dann leitend werden, wenn ein relativ positives Gate-Source-Potential an der Gateelektrode angelegt wird. In diesem Fall wird die Bildung der Ableitdiode 12 dadurch erreicht, daß man eine N-leitende Diffusionszone zur Bildung der Ableitdiode 12 in das P-leitende

Substrat eindiffundiert, deren Kathode an der Gateelektrode des Feldeffekttransistors 2 angeschlossen ist. Im Fall eines P-Kanal-FET wäre das Substrat aus N-leitendem Material, und die Ableitdiode 12 würde dadurch gebildet, daß eine P-leitende Zone in das N-leitende Material hinein diffundiert würde, und damit würde auch die Anode der Ableitdiode an der Gateelektrode des FET 2 angeschlossen. Die Ableitdiode 12 ist mit ihrem ersten Pol, der Kathode im Fall eines N-Kanal-FET, am Gateknotenpunkt des FET 2 und mit dem zweiten Pol, in diesem Fall der Anode, am Substrat-Potential $V_{sx}$ angeschlossen. Bei dieser Polung ist die Ableitdiode 12 dann in Sperrichtung vorgespannt, wenn der Gateknotenpunkt des FET 2 so vorgespannt ist, daß der FET leitet. In dieser Weise wird eine auf der Gateelektrode sich ansammelnde elektrostatische Ladung über den in Sperrichtung über die Ableitdiode fließenden Leckstrom nach dem Substrat abgeleitet werden. Für diejenigen Feldeffekttransistoren 2, die an ihren entsprechenden Wortleitungen angeschlossen bleiben, wird ein positiver Schaltimpuls auf der Wortleitung nicht durch die Ableitdiode auf der Substratspannung festgehalten werden, sondern der Impuls wird den ausgewählten Feldeffekttransistor einschalten, was beabsichtigt ist. Somit werden für einen N-Kanal-FET 2, dessen Gateelektrode von der Wortleitung abgetrennt ist, positive elektrostatische Ladungen auf der Gateelektrode über die Ableitdiode 12 durch den in Sperrichtung fließenden Leckstrom nach dem Substrat abgeleitet, so daß eine versehentlich positiv aufgeladene Gateelektrode den FET 2 nicht leitend macht. Falls die auf der Gateelektrode des abgetrennten Feldeffekttransistors 2 angesammelte elektrostatische Ladung negatives Vorzeichen hätte, dann würde diese Ladung über die in Durchlaßrichtung vorgespannte Ableitdiode 12 nach Erde abgeleitet werden.

Die Polung der Ableitdiode und ihre feste Verbindung mit der entsprechenden Gateelektrode des FET 2 macht die Belastung des Gateknotenpunkts dann zu einem Minimum, wenn die auftrennbare Verbindung mit der zugehörigen Wortleitung nicht unterbrochen ist, da die Ableitdiode dann, wenn für einen N-Kanal-FET auf der Wortleitung 6 ein positives Eingangssignal liegt, in Sperrichtung vorgespannt ist.

Fig. 2 zeigt eine Draufsicht auf einen Teil der Anordnung eines aus Feldeffekttransistoren bestehenden Festwertspeichers, der in Fig. 1 schematisch gezeigten Art. Die einzelne Speicherzelle besteht aus einem FET 2, der eine dünne Oxidschicht zwischen dem Substrat und der darüber liegenden metallischen Gateelektrode 3 aufweist, die zwischen der Source- oder Bit-Leitung 4a und der Drain- oder $V_{DD}$-Leitung 1 liegt. Die Gatemetallisierung 3 ist nur an der Diodendiffusionszone angeschlossen, die bei einem N-Kanal-FET eine N-leitende Diffusionszone ist, wodurch die Ableitdiode 12 gebildet ist. Die Gatemetallisierung ist dann anschließend über ein Verbindungsleitungsstück 14 an der Wortleitung 6 angeschlossen. Zum Abtrennen des Fet 2a von seiner entsprechenden Wortleitung 6a wird ein Laserstrahl selektiv längs der Linie 16 auf das Verbindungsleitungsstück 14 der die metallische Gateelektrode 3 mit der metallischen Wortleitung 6a verbindenen Metallisierungsschicht gerichtet. Wenn somit ein positiver Wortimpuls auf die Wortleitung 6a gelegt wird, dann würde der FET 2b aus seiner Bit-Leitung 4b das Potential $V_{DD}$ liefern, während der FET 2a auf seiner Bit-Leitung 4a keine Potentialänderung hervorrufen würde.

Fig. 3 zeigt das Schaltbild der einzelnen Zelle sowie den Ort der Leitungsunterbrechung 16 in bezug auf die Ableitdiode 12.

## Patentansprüche

1. Speicherzelle für programmierbare Festwertspeicher mit einem Feldeffekttransistor (2) dessen Drainelektrode an einer Drainspannung ($V_{DD}$) angeschlossen, dessen Sourceelektrode an einem Ausgangsknotenpunkt angekoppelt und dessen Gateelektrode (3) einerseits über eine wahlweise auftrennbare Leitung (14) an einer Wortleitung (6) angeschlossen ist und andererseits über eine Ableitdiode (12) an ein Bezugspotential angekoppelt ist, dadurch gekennzeichnet, daß die Ableitdiode (12) unmittelbar an der Gateelektrode angeschlossen und so gepolt ist, daß sie durch ein über die Wortleitung (6) angelegtes, den FET (2) entsperrendes Potential in Sperrichtung vorgespannt würde und daß die Auftrennstelle (16) zwischen der mit der Gateelektrode (3) verbundenen Elektrode der Ableitdiode (12) und der Wortleitung (6) liegt.

2. Speicherzelle nach Anspruch 1, dadurch gekennzeichnet, daß für einen N-Kanal-FET die Ableitdiode (12) mit ihrer Kathode an der Gateelektrode (3) des FET (2) angeschlossen ist.

3. Speicherzelle nach Anspruch 1, dadurch gekennzeichnet, daß für einen P-Kanal-FET die Ableitdiode (12) mit ihrer Anode an der Gateelektrode (3) des FET (2) angeschlossen ist.

## Revendications

1. Cellule d'emmagasinage pour mémoire inaltérable programmable comportant un transistor à effet de champ (2) muni d'une électrode de drain connectée à une tension de drain ($V_{DD}$), d'une électrode de source connectée à un noeud de sortie, et d'une électrode de porte (3) connectée d'une part, par une ligne (14) pouvant être sélectivement déconnectée, à une ligne de mots (6), et d'autre part, par une diode (12), à un potentiel de référence, caractérisée en ce que la diode (12) est directement connectée à l'électrode de porte et a ses électrodes disposées de telle façon que par l'application d'un potentiel par la ligne de mots (6) et l'exci-

tation du transistor (2), elle soit inversement polarisée, et en ce que le point (16) où s'effectue la déconnexion est disposé entre l'électrode de la diode (12) connectée à l'électrode de porte (3), et la ligne de mots (6).

2. Cellule d'emmagasinage selon la revendication 1, caractérisée en ce que pour un transistor à effet de champ à N canaux, la cathode de la diode (12) est connectée à l'électrode de porte (3) du transistor (2).

3. Cellule d'emmagasinage selon la revendication 1, caractérisée en ce que pour un transistor à effet de champ à P canaux, la cathode de la diode (12) est connectée à l'électrode de porte (3) du transistor (2).

**Claims**

1. Storage cell for programmable read only storages with a field effect transistor (2) having a drain electrode connected to a drain voltage ($V_{DD}$), a source electrode connected to an output node, and a gate electrode (3) connected on the one hand via a selectively disconnectable line (14) to a word line (6), and on the other via a diode (12) to a reference potential, characterized in that the diode (12) is directly connected to the gate electrode and poled in such a manner that by a potential applied via the word line (6) and actuating the FET (2) it would be reverse-biased, and in that the point of disconnection (16) is provided between the electrode of the diode (12) connected to the gate electrode (3), and the word line (6).

2. Storage cell as claimed in claim 1, characterized in that for an N-channel-FET the diode (12) is connected with its cathode to the gate electrode (3) of the FET (2).

3. Storage cell as claimed in claim 1, characterized in that for a P-channel-FET the diode (12) is connected with its anode to the gate electrode (3) of the FET (2).

**0 010 139**

FIG. 1

FIG. 2

FIG. 3

1